# EUROPÄISCHE PATENTANMELDUNG

(11) **EP 1 675 453 A2**
(43) Veröffentlichungstag der Anmeldung: **28.06.2006**
(21) Anmeldenummer: 05110130.1
(22) Anmeldetag: 28.10.2005
(51) Int. Cl.: H05K 13/08

(54) **Vorrichtung zum Beleuchten von Objekten, Sensorvorrichtung**

(30) Priorität: 22.12.2004 DE 102004061910
(71) Anmelder: SIEMENS AKTIENGESELLSCHAFT, 80333 München (DE)
(72) Erfinder: Besch, Karl-Heinz, 82140, Olching (DE); Froese-Peeck, Rüdiger, 81379, München (DE); Schauer, Christian, 81371, München (DE); Stredele, Bernhard, 82449, Uffing (DE)

(57) **Zusammenfassung**

Die Erfindung schafft eine Beleuchtungsvorrichtung mit einer ersten Beleuchtungseinheit (140, 240, 340) zum Beleuchten eines Messfeldes (170, 270, 370) unter einem ersten Beleuchtungswinkel und einer zweiten Beleuchtungseinheit (150, 250, 350) zum Beleuchten des Messfeldes (170, 270, 370) unter einem zweiten Beleuchtungswinkel. Zwischen der zweiten Beleuchtungseinheit (150, 250, 350) und dem Messfeld (170, 270, 370) ist ein optisches Element (151, 252, 352) angeordnet, welches den Strahlengang zwischen der zweiten Beleuchtungseinheit (150, 250, 350) und dem Messfeld (170, 270, 370) derart beeinflusst, dass der Strahlengang außerhalb der direkten geometrischen Verbindung zwischen der zweiten Beleuchtungseinheit (150, 250, 350) und dem Messfeld (170, 270, 370) verläuft. Erfindungsgemäß sind beide Beleuchtungseinheiten (140, 240, 340, 150, 250, 350) an einem gemeinsamen Schaltungsträger (135, 235a/b, 335a/b) angebracht. Das optische Element kann ein Lichtleitelement (151) sein, welches eine mit der zweiten Beleuchtungseinheit (150) optisch gekoppelte Lichteintrittsfläche (151a) und eine von dem gemeinsamen Schaltungsträger (135) beabstandete Lichtaustrittsfläche (151b) aufweist. Ebenso kann das optische Element ein Refraktionselement (252, 352) sein, welches von der zweiten Beleuchtungseinheit (250, 350) beabstandet angeordnet ist und den Strahlengang zwischen der zweiten Beleuchtungseinheit (250, 350) und dem Messfeld (270, 370) durch eine Brechung an zumindest einer Grenzfläche beeinflusst.

## Beschreibung

Die Erfindung betrifft eine Vorrichtung zum Beleuchten von Objekten, insbesondere zum Beleuchten von elektronischen Bauelementen und/oder von auf Bauelementesträgern aufgebrachten Markierungen, wobei unterschiedliche Beleuchtungseinheiten das zu beleuchtende Objekt unter unterschiedlichen Beleuchtungswinkeln beleuchten. Die Erfindung betrifft ferner eine Sensorvorrichtung zur visuellen Erfassung von Objekten, insbesondere zur Erfassung von elektronischen Bauelementen und/oder von auf Bauelementeträgern aufgebrachten Markierungen, welche einen Lichtdetektor und eine Beleuchtungsvorrichtung der oben genannten Art aufweist.

Bei der automatischen Bestückung von Bauelementeträgern in so genannten Bestückautomaten werden Bauelemente von einer Bauelemente-Zuführeinrichtung an bestimmten Abholpositionen bereitgestellt und von einem Bestückkopf abgeholt, welcher mittels eines Positioniersystems innerhalb eines Arbeitsbereiches positioniert werden kann. Die abgeholten Bauelemente werden von dem Bestückkopf zu einer Bestückposition transportiert und auf dem zu bestückenden Bauelementeträger an durch entsprechende Anschlussflächen definierte Einbaupositionen aufgesetzt.

Aufgrund der zunehmenden Miniaturisierung von elektronischen Bauelementen ist ein präziser Bestückvorgang nur durch eine genaue optische Lagevermessung der von dem Bestückkopf aufgenommenen Bauelemente möglich. Ebenso ist eine präzise Lagevermessung des zu bestückenden Bauelementeträgers erforderlich, damit von dem Bestückkopf die richtigen Bestückpositionen präzise angefahren werden können. Die Lagevermessung von Bauelementeträgern erfolgt üblicherweise anhand spezieller an den jeweiligen Bauelementeträgern angebrachten Markierungen.

Ein moderner Bestückautomat zeichnet sich jedoch nicht nur durch eine hohe Bestückgenauigkeit, sondern auch durch eine hohe Bestückleistung aus. Unter dem Begriff Bestückleistung ist in diesem Zusammenhang die maximale Anzahl an Bauelementen zu verstehen, die innerhalb einer bestimmten Zeiteinheit von der Bauelement-Zuführeinrichtung abgeholt und auf der Leiterplatte aufgesetzt werden können.

Um sowohl eine hohe Bestückgenauigkeit als auch eine hohe Bestückleistung zu erreichen, muss demzufolge die Positionsvermessung von Bauelement und Leiterplatte sowohl sehr präzise als auch sehr schnell erfolgen. Dafür ist neben einem hochwertigen Kamerasystem auch eine Beleuchtungsvorrichtung erforderlich, welche die zu erfassenden Objekte unter verschiedenen Beleuchtungswinkeln und/oder mit einem Licht mit unterschiedlichen Spektralanteilen mit hoher Lichtintensität beleuchtet, so dass eine Vielzahl von verschiedenen Objekten mit unterschiedlichen optischen Eigenschaften zuverlässig vermessen werden können. Die Wahl von Beleuchtungswinkel bzw. Beleuchtungsspektrum hängt dabei von dem optischen Verhalten des jeweils zu erfassenden Objektes und gegebenenfalls auch von dem optischen Verhalten des Hintergrundes ab, vor dem das jeweilige Objekt aufgenommen wird.

Aus der DE 101 28 476 C2 ist eine optische Sensorvorrichtung bekannt, bei der drei unterschiedliche Beleuchtungseinheiten vorgesehen sind, welche das zu erfassende Objekt jeweils aus einem unterschiedlichen Winkel beleuchten. Einige der Beleuchtungseinheiten weisen zumindest zwei in voneinander unterschiedlichen Spektralbereichen emittierende Leuchtelemente auf. Sämtliche Leuchtelemente sind mittels einer Steuervorrichtung unabhängig voneinander ansteuerbar, so dass das Beleuchtungsspektrum jeweils optimal auf die jeweilige Situation angepasst werden kann. Die optische Sensorvorrichtung hat jedoch den Nachteil, dass die die drei Beleuchtungseinheiten aufweisende Beleuchtungsvorrichtung nur auf aufwendige Art und Weise hergestellt werden kann, da die entsprechenden Leuchtelemente an unterschiedlichen Positionen auf unterschiedlichen Ebenen innerhalb der Beleuchtungsvorrichtung angebracht werden müssen.

Der Erfindung liegt die Aufgabe zugrunde, eine Vorrichtung zum Beleuchten bzw. eine Vorrichtung zum Erfassen von Objekten zu schaffen, welche eine Vielzahl von verschiedenen Beleuchtungen ermöglicht und mittels einer einfachen und damit kostengünstigen Montagetätigkeit aufgebaut werden kann.

Diese Aufgabe wird gelöst durch eine Vorrichtung zum Beleuchten von Objekten, insbesondere zum Beleuchten von elektronischen Bauelementen und/oder von auf Bauelementeträgern aufgebrachten Markierungen mit den Merkmalen des unabhängigen Anspruchs 1.

Die erfindungsgemäße Beleuchtungsvorrichtung umfasst eine erste Beleuchtungseinheit zum Beleuchten eines Messfeldes unter einem ersten Beleuchtungswinkel und eine zweite Beleuchtungseinheit zum Beleuchten des Messfeldes unter einem zweiten Beleuchtungswinkel. Zwischen der zweiten Beleuchtungseinheit und dem Messfeld ist ein optisches Element angeordnet, welches den Strahlengang zwischen der zweiten Beleuchtungseinheit und dem Messfeld derart beeinflusst, dass der Strahlengang außerhalb der direkten geometrischen Verbindung zwischen der zweiten Beleuchtungseinheit und dem Messfeld verläuft. Eine einfache Montage der Beleuchtungsvorrichtung wird erfindungsgemäß dadurch erreicht, dass sowohl die erste als auch die zweite Beleuchtungseinheit an einem gemeinsamen Schaltungsträger angebracht sind.

Gemäß Anspruch 2 ist zusätzlich eine dritte Beleuchtungseinheit zum Beleuchten des Messfeldes unter einem dritten Beleuchtungswinkel vorgesehen, wobei die dritte Beleuchtungseinheit ebenfalls an dem gemeinsamen Schaltungsträger angebracht ist. Der sämtliche Beleuchtungseinheiten aufweisende gemeinsame Schaltungsträger kann insbesondere dann auf einfache Weise hergestellt werden, wenn die Leuchtelemente, welche für die drei Beleuchtungseinheiten vorgesehen sind, so genannte SMD (Surface Mount Device) Bauelemente sind. Als Leuchtelemente eignen sich demzufolge insbesondere Leuchtdioden, welche preiswert sind und bei geringem Strombedarf eine hohe Lichtausbeute liefern.

Gemäß Anspruch 3 weist die Sensorvorrichtung zusätzlich einen oberhalb des Messfeldes angeordneten teildurchlässigen Spiegel auf, welcher eine senkrechte Beleuchtung des Messfeldes durch die dritte Beleuchtungseinheit ermöglicht. Dabei kann der Strahlengang des dritten Beleuchtungslichts auch über einen zusätzlichen Reflektor und/oder über ein Lichtstreuelement zur Erzeugung von diffusem Beleuchtungslicht verlaufen.

Gemäß Anspruch 4 sind die Beleuchtungseinheiten derart eingerichtet, dass sie Beleuchtungslicht in unterschiedlichen Spektralbereichen emittieren können. Durch eine entsprechende Ansteuerung der jeweiligen Beleuchtungseinheiten kann somit das Beleuchtungslicht auf eine Vielzahl von verschiedenen Situationen, welche durch das optische Verhalten der zu erfassenden Objekte bestimmt sind, optimal angepasst werden. Die unterschiedlichen Spektralbereiche können entweder dadurch realisiert werden, dass unterschiedliche Beleuchtungseinheiten unterschiedliche Spektralverteilungen an Beleuchtungslicht emittieren oder dass eine Beleuchtungseinheit verschiedene Spektralbereiche abdeckt, was am einfachsten dadurch realisiert werden kann, dass für eine Beleuchtungseinheit mehrere spektral unterschiedliche Leuchtelemente vorgesehen sind.

Gemäß Anspruch 5 ist eine elektronische Treiberschaltung zum Ansteuern der Beleuchtungseinheiten ebenfalls an dem gemeinsamen Schaltungsträger angebracht. Dies hat den Vorteil, dass alle für die Beleuchtungsvorrichtung erforderlichen elektronischen und optoelektronischen Bauelemente auf dem gemeinsamen Schaltungsträger angeordnet sind und somit auch für die elektronische Ansteuerung der unterschiedlichen Beleuchtungseinheiten keine zusätzliche Leiterplatte erforderlich ist.

Die Beleuchtungsvorrichtung gemäß Anspruch 6 weist zusätzlich ein Streuelement auf, welches im Strahlengang des ersten Beleuchtungslichts angeordnet ist und somit eine diffuse Beleuchtung der zu erfassenden Objekte durch die erste Beleuchtungseinheit ermöglicht. Eine diffuse Beleuchtung ist insbesondere dann von Vorteil, wenn die zu erfassenden Objekte zumindest in Teilbereichen reflektierend sind, da bei einer diffusen Beleuchtung Lichtreflexionen erheblich geschwächt sind, welche die Erfassung des jeweiligen Objekts erschweren. Es wird darauf hingewiesen, dass das Streuelement auch einstückig mit dem optischen Element ausgebildet sein kann, so dass nicht nur die erste Beleuchtungseinheit, sondern auch die zweite Beleuchtungseinheit eine diffuse Beleuchtung mit den genannten Vorteilen bewirkt. Eine Integration des Streuelements in das optische Element erlaubt eine weiter vereinfachte Montage der Beleuchtungsvorrichtung.

Die Vorrichtung nach Anspruch 7, bei der das optische Element direkt oder indirekt an dem gemeinsamen Schaltungsträger befestigt ist, ermöglicht eine besonders einfache und damit auch kostengünstige Montage der Beleuchtungsvorrichtung.

Gemäß der bevorzugten Ausführungsform nach Anspruch 8 ist das optische Element ein Lichtleitelement, welches eine mit der zweiten Beleuchtungseinheit optisch gekoppelte Lichteintrittsfläche und eine von dem gemeinsamen Schaltungsträger beabstandete Lichtaustrittsfläche aufweist. Dies hat den Vorteil, dass insbesondere bei einer parallelen Anordnung von gemeinsamen Schaltungsträger und Messfeld auch dann eine sehr flache Beleuchtung realisiert werden kann, wenn die Beleuchtungseinheiten auf einem vergleichsweise kleinflächigen Schaltungsträger angeordnet sind. Ein kleiner Schaltungsträger hat den großen Vorteil, dass die gesamte Beleuchtungsvorrichtung in einer kompakten Bauform aufgebaut werden kann und somit als vielseitig einsetzbare Beleuchtungsvorrichtung auch bei einem geringen Platzangebot eingesetzt werden kann. Im Gegensatz zu einer steilen Beleuchtung ist unter einer flachen Beleuchtung eine Beleuchtungssituation zu verstehen, bei der der Winkel, mit dem die Lichtstrahlen auf das Messfeld treffen, zumindest kleiner als 45° ist. Dabei wird der Beleuchtungswinkel zwischen den einfallenden Lichtstrahlen und der Ebene des Messfeldes gemessen. Im Gegensatz dazu zeichnet sich eine steile Beleuchtung dadurch aus, dass der Beleuchtungswinkel im Bereich zwischen 45° und 90° liegt, wobei ein Beleuchtungswinkel von 90° eine senkrechte Beleuchtung des Messfeldes darstellt.

Das Lichtleitelement ist beispielsweise ein herkömmlicher Lichtwellenleiter oder ein optisch transparentes Kunststoffteil, welches auf einfache Weise insbesondere durch bekannte Spritzgussverfahren hergestellt werden kann.

Eine weitere besonders vorteilhafte Ausführungsform ergibt sich aus den Merkmalen des Anspruchs 9. Demnach ist das optische Element ein Refraktionselement, welches von der zweiten Beleuchtungseinheit beabstandet angeordnet ist und den Strahlengang zwischen der zweiten Beleuchtungseinheit und dem Messfeld durch Brechung an zumindest einer Grenzfläche des Refraktionselementes beeinflusst. Insbesondere bei einer senkrechten Anordnung von gemeinsamen Schaltungsträgern und Messfeld kann damit eine sehr steile Beleuchtung bereits mit einem kleinen Schaltungsträger realisiert werden, so dass auch in diesem Fall die gesamte Beleuchtungsvorrichtung in einer sehr kompakten Bauform aufgebaut werden kann.

Gemäß Anspruch 10 weist das Refraktionselement ein optisches Prisma auf, welches eine einfache und kostengünstige Realisierung des Refraktionselements darstellt.

Die vorteilhafte Ausführungsform nach Anspruch 11 mit einer Zylinderlinse als Refraktionselement hat den Vorteil, dass innerhalb des Messfeldes sowohl eine hohe Beleuchtungsintensität als auch eine große Bandbreite an Beleuchtungswinkeln realisiert werden kann. Die große Bandbreite an Beleuchtungswinkeln hat den Vorteil, dass die Beleuchtung in besonders vorteilhafter Weise für runde bzw. für zylindrische Körper mit einer spiegelnden Oberfläche geeignet ist, da die Intensität von störenden Reflexionen deutlich reduziert sind, welche Reflexionen die Auswertung eines von einer Kamera aufgenommenes Bildes erheblich stören.

Es wird darauf hingewiesen, dass das eine Zylinderlinse aufweisende Refraktionselement eine Rotationssymmetrie aufweisen kann, wobei die entsprechende Rotationsachse mit der optischen Achse der Beleuchtungsvorrichtung zusammenfällt. In diesem Fall weisen auch die Zylinderlinsen eine um die optische Achse konzentrische Form auf. Dies ermöglicht eine weitgehend homogene Beleuchtung mit unterschiedlichen Azimutwinkeln, d. h. mit unterschiedlichen Beleuchtungsrichtungen, die relativ zu der Messebene alle denselben Beleuchtungswinkel aufweisen.

Einen guten Kompromiss zwischen Herstellungsaufwand und gleichmäßiger Beleuchtung unter verschiedenen Azimutwinkeln erhält man mit einer mehreckigen, insbesondere mit einer achteckigen Anordnung, welche ebenfalls eine Symmetrie zur optischen Achse aufweist.

Gemäß Anspruch 12 ist das Refraktionselement derart ausgebildet, dass es zusätzlich eine Lichtstreuung bewirkt. In diesem Fall hat das optische Element zwei Funktionen: (a) Die vorteilhafte Beeinflussung des Beleuchtungswinkels zur Realisierung einer kompakten Bauform und (b) die Erzeugung von diffusem Licht zur Reduzierung von störenden direkten Lichtreflexen.

Die der Erfindung zugrunde liegende Aufgabe wird ferner gelöst durch eine Sensorvorrichtung zur visuellen Erfassung von Objekten, insbesondere zur Erfassung von elektronischen Bauelementen und/oder von auf Bauelementeträgern aufgebrachten Markierungen mit den Merkmalen des Anspruchs 13. Die erfindungsgemäße Sensorvorrichtung umfasst einem Lichtdetektor und einer Vorrichtung zum Beleuchten von Objekten nach einem der Ansprüche 1 bis 12.

Gemäß Anspruch 14 ist der Lichtdetektor ein Zeilen- oder ein Flächensensor, welcher insbesondere mittels eines herkömmlichen CCD (Charge Coupled Device) Chips oder mittels eines CMOS (Complementary Metal Oxide Semiconductor) Chips realisiert verwendet werden kann. CCD-Sensoren haben den Vorteil, dass sie eine hohe Empfindlichkeit aufweisen und zudem preiswerte Standard-Elektronikbauteile sind.

Bei Verwendung eines Zeilensensors erfolgt die Vermessung eines Objektes durch eine Relativbewegung zwischen dem Objekt und der Sensorvorrichtung. Dabei werden nacheinander eine Mehrzahl von eindimensionalen Bildzeilen aufgenommen und in einer der Sensorvorrichtung nachgeschalteten Bildauswerteeinheit zu einem flächigen Bild des Objekts zusammengesetzt.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine Sensorvorrichtung, bei der der gemeinsame Schaltungsträger parallel zu dem Messfeld angeordnet ist,
- Figur 2: eine Sensorvorrichtung, bei der der gemeinsame Schaltungsträger senkrecht zu dem Messfeld angeordnet ist, und
- Figur 3: eine Sensorvorrichtung, bei der Zylinderlinsen auf vorteilhafte Weise eine fokussierte Beleuchtung des Messfeldes ermöglichen.

An dieser Stelle bleibt anzumerken, dass sich in der Zeichnung die Bezugszeichen einander entsprechender Komponenten lediglich in ihrer ersten Ziffer unterscheiden.

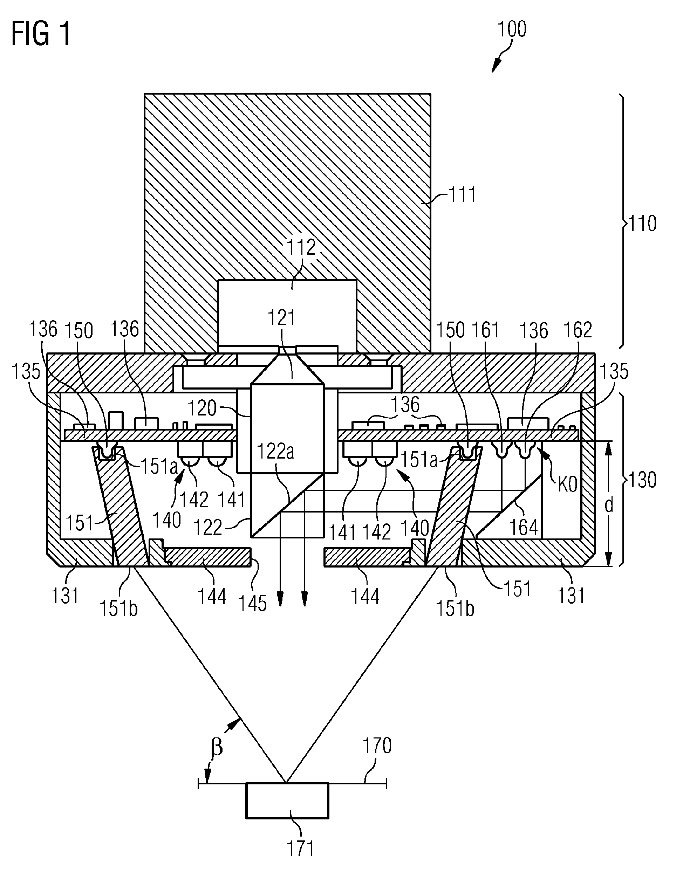

Figur 1 zeigt ein Bilderkennungssystem 100 gemäß einem ersten Ausführungsbeispiel der Erfindung. Das Bilderkennungssystem 100 umfasst eine Kamera 110 sowie eine Beleuchtungsvorrichtung 130. Die Kamera 110 weist ein Gehäuse 111 auf, in dem ein CCD-Sensor 112 sowie eine nicht dargestellte elektronische Schaltung angeordnet sind, welche den CCD-Sensor 112 ansteuert und über welche von dem CCD-Sensor 112 aufgenommene Bilddaten an eine ebenfalls nicht dargestellte Bildauswerteeinheit übertragen werden. Der Kamera 110 ist ferner ein Tubus 120 zugeordnet, welcher symmetrisch zu der optischen Achse des CCD-Sensors 112 befestigt ist und welcher eine Optik 121 sowie einen Teilerwürfel 122 mit einer halbreflektierenden Grenzfläche 122a aufweist. Wie weiter unter erläutert, erlaubt der Teilerwürfel 122 eine senkrechte Beleuchtung eines Messfeldes 170, welches über die Optik 121 von der Kamera 110 erfasst wird.

Die Beleuchtungsvorrichtung 130 weist ein Gehäuse 131 auf, in welchem eine Leiterplatte 135 angeordnet ist. Die Leiterplatte 135 dient als gemeinsamer Schaltungsträger für eine Mehrzahl von elektronischen und optoelektronischen Bauteilen. Sämtliche elektronischen und optoelektronischen Bauteile sind typischerweise SMD Bauelemente, welche in herkömmlicher Weise auf der gemeinsamen Leiterplatte 135 bestückt sind, so dass die Beleuchtungseinheit 130 kostengünstig hergestellt werden kann. Da sich zudem sämtliche für die Beleuchtung erforderlichen Komponenten auf der gemeinsamen Leiterplatte 135 befinden, kann die Beleuchtungseinheit 130 mit einer entsprechend bestückten Leiterplatte 135 einfach montiert werden.

Auf der gemeinsamen Leiterplatte 135 sind ferner eine Vielzahl von elektronischen Bauelementen 136 angeordnet, welche als Treiberschaltungen für drei Beleuchtungseinheiten, eine erste Beleuchtungseinheit 140, eine zweite Beleuchtungseinheit 150 und eine dritte Beleuchtungseinheit 160 dienen.

Die erste Beleuchtungseinheit 140 und die zweite Beleuchtungseinheit 150 weisen jeweils Leuchtdioden auf, die symmetrisch zu der optischen Achse der Beleuchtungsvorrichtung 130 angeordnet sind, wobei die optische Achse der Beleuchtungsvorrichtung 130 mit der optischen Achse der Kamera 110 zusammenfällt. An dieser Stelle wird darauf hingewiesen, dass die Anzahl der Leuchtdioden der jeweiligen Beleuchtungseinheit nicht auf die in Figur 1 dargestellte Anzahl beschränkt ist. Zur Erzielung einer intensiven und möglichst gleichmäßigen Beleuchtung ohne Vorzugsrichtungen können eine Vielzahl von Leuchtdioden nicht nur in der Zeichenebene der Figur 1, sondern auch in anderen nicht dargestellten Schnittebenen symmetrisch zu der optischen Achse der Beleuchtungsvorrichtung 130 angeordnet sein. So können die Leuchtdioden beispielsweise auf einem konzentrischen Kreis um die optische Achse der Beleuchtungsvorrichtung 130 oder auf den Seitenkanten eines Rechtecks, insbesondere eines Quadrats, angeordnet sein, welches Rechteck bzw. Quadrat ebenfalls symmetrisch zu der optischen Achse der Beleuchtungsvorrichtung 130 liegt.

Die erste Beleuchtungseinheit 140 umfasst eine Mehrzahl von inneren Leuchtdioden 141 sowie eine Mehrzahl von äußeren Leuchtdioden 142, von denen in der in Figur 1 dargestellten Querschnittsansicht jeweils lediglich zwei Leuchtdioden 141 bzw. 142 zu erkennen sind. Dabei können die inneren Leuchtdioden 141 Licht mit einem ersten Beleuchtungsspektrum und die äußeren Leuchtdioden 142 Licht mit einem zweiten Beleuchtungsspektrum aussenden, welches unterschiedlich zu dem ersten Beleuchtungsspektrum ist. Die Leuchtdioden 141 und 142 können jedoch auch von dem selben Typ sein und Licht mit dem gleichen Wellenlängenspektrum aussenden, so dass durch eine hohe Anzahl an identischen Leuchtdioden auf dem Messfeld 170 durch die erste Beleuchtungseinheit 140 eine hohe Beleuchtungsintensität erreicht wird.

Unterschiedliche Beleuchtungsspektren der Leuchtdioden 141 und der Leuchtdioden 142 haben den Vorteil, dass unter der Voraussetzung einer individuellen Ansteuerung der einzelnen Leuchtdioden 141 bzw. 142 das Beleuchtungsspektrum optimal auf die optischen Eigenschaften eines zu erfassenden Messobjekts 171 angepasst werden kann, welches zu Erfassung derart positioniert wird, dass die Oberfläche des Messobjekts 171 mit dem Messfeld 170 zusammenfällt.

Das von den Leuchtdioden 141 und 142 ausgesandte erste Beleuchtungslicht trifft auf eine Streuscheibe 141, welche dafür sorgt, dass das Messfeld 170 durch ein diffuses erstes Beleuchtungslicht erhellt wird. Damit die Kamera 110 das Messfeld 170 weitgehend störungsfrei erfassen kann, ist in der Streuscheibe 144 eine zur optischen Achse der Beleuchtungsvorrichtung 130 symmetrische Öffnung 145 ausgebildet.

Die zweite Beleuchtungsvorrichtung 150 weist gemäß dem hier dargestellten Ausführungsbeispiel lediglich eine Gruppe von Leuchtdioden auf. Es wird allerdings darauf hingewiesen, dass auch für die zweite Leuchteinheit 150 mehrere Gruppen von Leuchtdioden verwendet werden können, so dass die oben in Zusammenhang mit der Beschreibung der ersten Beleuchtungsvorrichtung 141 erläuterten Vorteile einer hohen Lichtintensität bzw. eines spektral abstimmbaren Beleuchtungslichtes auch für die zweite Beleuchtungseinheit 150 gewinnbringend eingesetzt werden können.

Die Leuchtdioden 150 sind jeweils mit einem Leichtleitelement 151 gekoppelt, welches eine Licht-Eintrittsfläche 151a und eine Licht-Austrittsfläche 151b aufweist. Die Lichtleitelemente 151 sind aus einem optisch transparenten Kunststoff bevorzugt durch bekannte Spritzgieß-Verfahren hergestellt. Bei einer guten optischen Ankopplung der Eintrittsflächen 151a zu den jeweiligen Leuchtdioden 150 und bei einer geringen optischen Dämpfung der Lichtleitelemente 151 stellen somit die Austrittsflächen 151b eine um einen Abstand d von der gemeinsamen Leiterplatte 135 beabstandete Quasi-Lichtquelle dar. Bei einer entsprechenden Winkellage der länglichen Lichtleitelemente 151 zu der gemeinsamen Leiterplatte 135 ist der resultierende Beleuchtungswinkel β, welcher bevorzugt ungefähr 45° beträgt, kleiner als derjenige Winkel, den eine direkte Beleuchtung des Messfeldes 170 durch die Leuchtdioden 150 bewirken würde. Anders ausgedrückt bedeutet dies, dass eine relativ flache Beleuchtung durch die zweite Beleuchtungseinheit 150 auch mit einer relativ kompakten Beleuchtungseinheit 130, d. h. bei einer geringen Beabstandung der Leuchtdioden 150 von der optischen Achse der Beleuchtungsvorrichtung 130 realisiert werden kann. Ohne die Verwendung der Lichtleitelemente 151 müssten zur Erzielung eines gleichen Beleuchtungswinkels β die Leuchtdioden der zweiten Beleuchtungseinheit 150 weiter von der optischen Achse der Beleuchtungseinheit 130 beabstandet oder auf separaten Schaltungsträgern angeordnet sein.

Die dritte Beleuchtungseinheit 160 umfasst zwei Leuchtdioden 161 und 162, welche ebenso wie die Leuchtdioden 141 und 142 der ersten Beleuchtungseinheit 140 gleiches oder spektral unterschiedliches Beleuchtungslicht emittieren können. Über einen Umlenkspiegel 164 wird das von den Leuchtdioden 161 und 162 ausgesandte Licht auf den Teilerwürfel 122 gelenkt, so dass bei einem Reflexions-Koeffizienten der Grenzfläche 122a von 0,5 die Hälfte des Beleuchtungslichtes als senkrechte Beleuchtung auf das zu erfassende Messobjekt 171 trifft, welches beispielsweise ein von einer nicht dargestellten Haltevorrichtung eines Bestückkopfes gehaltenes Bauelement ist.

Die Beleuchtungsvorrichtung 130 hat den Vorteil, dass sämtliche zur Beleuchtung erforderlichen Leuchtdioden und Bauelemente zur Ansteuerung dieser Leuchtdioden in SMD Technik auf der gemeinsamen Leiterplatte 135 aufgebaut sind. Stark unterschiedliche Beleuchtungswinkel werden bei einer kompakten Bauweise der Beleuchtungsvorrichtung 130 dadurch erzielt, dass (a) eine schräge und bevorzugt diffuse Beleuchtung durch die Leuchtdioden 141 und 142 der ersten Beleuchtungseinheit 140, (b) eine flache Beleuchtung durch die zweite Beleuchtungseinheit 150 in Verbindung mit den Lichtleitelementen 151 und (c) eine senkrechte Beleuchtung durch die dritte Beleuchtungseinheit 160 in Verbindung mit dem Umlenkspiegel 164 und dem Teilerwürfel 122 erzielt wird.

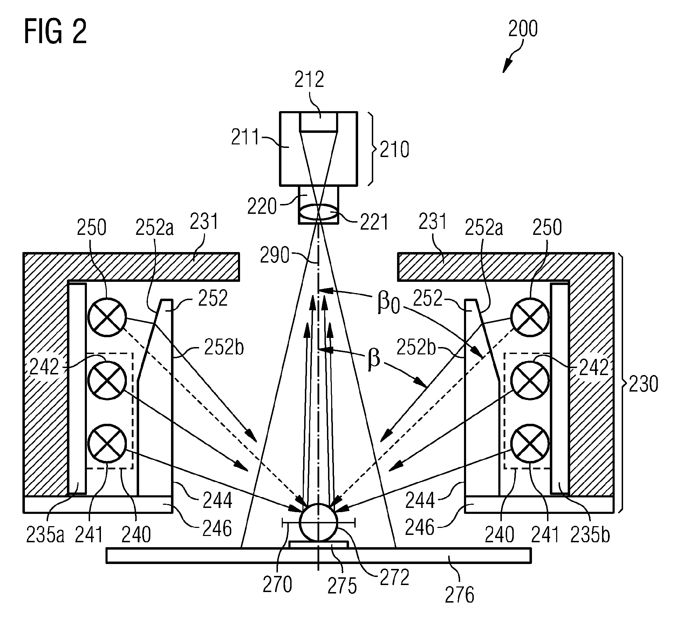

Figur 2 zeigt ein Bilderkennungssystem 200 mit einer Kamera 210 und einer Beleuchtungsvorrichtung 230, bei der zwei Beleuchtungseinheiten in einer Ebene senkrecht zu einem zu erhellenden Messfeld 270 angeordnet sind. Die Kamera 210 umfasst ein Gehäuse 211, in dem ein CCD-Sensor 212 angeordnet ist. Der Kamera 210 ist ein Tubus 220 zugeordnet, welcher als Halterung für eine Optik 221 dient, über welche das Messfeld 270 auf den flächigen CCD-Sensor 212 abgebildet wird.

Die Beleuchtungsvorrichtung 230 umfasst ein Gehäuse 231, in dem zumindest zwei Leiterplatten 235a und 235b befestigt sind. Die beiden Leiterplatten 235a und 235b, welche in der dargestellten Querschnittsansicht zu erkennen sind, können getrennte Leiterplatten oder auch bevorzugt eine einzige Leiterplatte sein, welche eine runde Form aufweist und um eine optische Achse 290 der Beleuchtungsvorrichtung 230 angeordnet ist. Alternativ kann eine gemeinsame Leiterplatte auch dadurch realisiert sein, dass mehrere steife Unter-Leiterplatten 235a und 235b in bekannter Weise durch so genannte Flexverbindungen in einer winkligen Anordnung insbesondere in Form eines Achtecks miteinander verbunden und symmetrisch um die optische Achse 290 herum angeordnet sind.

Die gemeinsamen Leiterplatte 235a bzw. 235b dient als Träger für eine erste Beleuchtungseinheit 240 und für eine zweite Beleuchtungseinheit 250, so dass auch die Beleuchtungsvorrichtung 230 auf einfache Weise montiert werden kann.

Die erste Beleuchtungseinheit 240 umfasst eine untere Leuchtdiode 241 und eine obere Leuchtdiode 242, welche, wie zuvor anhand von Figur 1 beschrieben, entweder spektral gleiches oder spektral unterschiedliches Licht emittieren. Das von den Leuchtdioden 241 und 242 ausgesandte Beleuchtungslicht trifft auf ein Streuelement 244, welches über eine Halterung 246 an dem Gehäuse 231 befestigt ist. Die Leuchtdioden 241 und 242 der ersten Beleuchtungseinheit 240 bewirken somit eine diffuse Beleuchtung eines im Messfeld 270 angeordneten Messobjekts 272. Dabei wird das Messobjekt 272 unter verschiedenen Winkeln beleuchtet, so dass auch bei einem gewölbten und stark reflektierenden Messobjekt, beispielsweise einem Bauelement mit gewölbten metallischen Anschlussflächen, im Vergleich zu einer direkten Beleuchtung unter einem festen Beleuchtungswinkel eine gleichmäßige Beleuchtung realisiert wird und somit lediglich Reflexe mit deutlich geringerer Intensität auftreten. Figur 2 zeigt schematisch ein derartiges gewölbtes Bauelement 272, welches auf einer Anschlussfläche 275 einer Leiterplatte 260 platziert ist.

Die zweite Beleuchtungseinheit 250 umfasst eine Leuchtdiode, deren ausgesandtes Licht auf einem abgeschrägten Teil des Streuelements 244 trifft, welcher Teil als Prisma ein so genanntes Refraktionselement 252 darstellt. Infolge der Brechung des von der Leuchtdiode 250 ausgesandten Beleuchtungslichts an einer Eintrittsfläche 252a und an einer Austrittsfläche 252b des Prismas 252 wird im Ergebnis das Messobjekt 272 unter einem relativ steilen Beleuchtungswinkel β beleuchtet. Wie aus Figur 2 ersichtlich, ist dieser Winkel β deutlich kleiner als derjenige Winkel β₀, unter dem das Messobjekt 272 ohne den Einfluss des Refraktionselementes 252 beleuchtet werden würde. Auf diese Weise können steile Beleuchtungswinkel erzielt werden, die ohne den Einsatz des Refraktionselementes 252 nur dann realisiert werden könnten, wenn die Höhe der vertikal angeordneten gemeinsamen Leiterplatte 235a, 235b deutlich größer und somit die Bauform der Beleuchtungsvorrichtung ebenfalls größer wäre als die in Figur 2 dargestellte kompakte Bauweise der Beleuchtungsvorrichtung 230.

An dieser Stelle wird darauf hingewiesen, dass in Figur 2 die Beleuchtungswinkel β und β₀ aus Gründen der Übersichtlichkeit relativ zu der optischen Achse 290 und nicht relativ zu der Messebene 170 eingezeichnet sind, wie dies in Figur 1 der Fall ist. In beiden Fällen trägt jedoch ein optisches Element, welches bei dem in Figur 1 dargestellten Ausführungsbeispiel ein Lichtleitelement 151 und bei dem in Figur 2 dargestellten Ausführungsbeispiel ein Refraktionselement 252 ist, dazu bei, dass eine Beleuchtungsvorrichtung, welche eine Beleuchtung unter stark unterschiedlichen Beleuchtungswinkeln ermöglicht, innerhalb einer kompakten Bauform aufgebaut werden kann.

Die Beleuchtungsvorrichtung 230 zeichnet sich ferner dadurch aus, dass mehrere Lichtquellen für verschiedene Beleuchtungswinkel auf einer gemeinsamen Leiterplatte 235a bzw. 235b angeordnet sind und somit eine einfache und zügige Montage der Beleuchtungsvorrichtung 230 erlaubt. Durch die Integration des als optisches Prisma ausgebildeten Refraktionselements 252 in das Streuelement 244 kann eine diffuse Beleuchtung unter einer Vielzahl von verschiedenen Beleuchtungswinkeln auch bei einer kompakten Bauform der Beleuchtungsvorrichtung 230 realisiert werden.

Das mit dem Refraktionselement 252 kombinierte Streuelement 244 ist aus einem transparenten Kunststoff und kann beispielsweise in einem Spritzgussverfahren hergestellt werden. Das Refraktionselement 252 weist eine zylindersymmetrische oder eine achteckige Form auf und ist symmetrisch zu der optischen Achse 290 der Beleuchtungsvorrichtung 230 angeordnet. Auf diese Weise kann bei kompakter Bauweise mit einer hohen Beleuchtungsintensität eine homogene Ausleuchtung bei einer großen Bandbreite von Beleuchtungswinkeln erzielt werden.

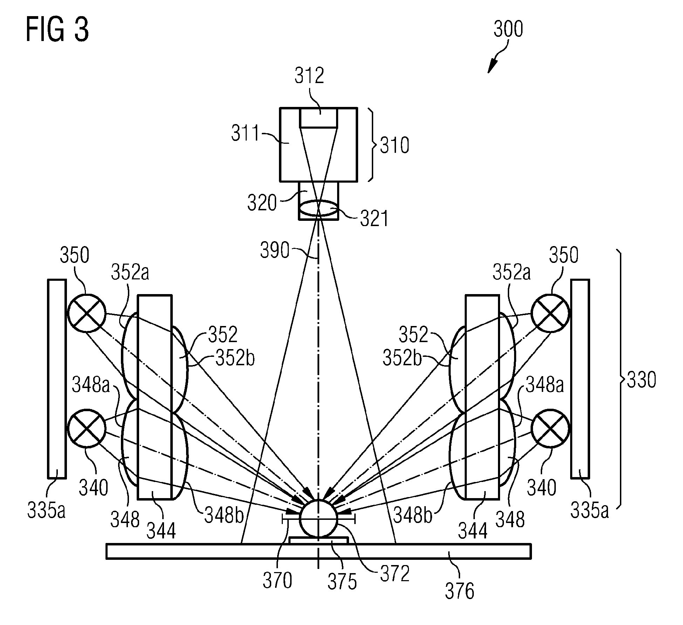

Figur 3 zeigt gemäß einem weiteren Ausführungsbeispiel der Erfindung ein Bilderkennungssystem 300, welches eine Kamera 310 und eine Beleuchtungsvorrichtung 330 aufweist. Die Kamera 310 ist mit der in Figur 2 dargestellten Kamera 210 identisch und wird deshalb an dieser Stelle nicht noch einmal erläutert.

Die Beleuchtungsvorrichtung 330 umfasst Leiterplatten 335a und 335b. Wie bereits zuvor anhand von Figur 2 beschrieben, können die Leiterplatten auch in Form einer einstückigen Leiterplatte aufgebaut sein. Die Leiterplatte 335a bzw. 335b dient als Träger für eine erste Beleuchtungseinheit 340 und eine zweite Beleuchtungseinheit 350. Beide Beleuchtungseinheiten weisen gemäß dem hier dargestellten Ausführungsbeispiel jeweils eine Leuchtdiode auf. Das von den beiden Leuchtdioden 340 und 350 ausgesandte Beleuchtungslicht trifft zunächst auf ein Streuelement 344, bevor es ein in einem Messfeld 370 positioniertes Messobjekt 372 erreicht. Das Messobjekt 372 ist beispielsweise ein elektronisches Bauelement mit gewölbten Anschlusskontakten, welche auf einer Anschlussfläche 375 einer Leiterplatte 376 platziert sind.

Für jede Beleuchtungseinheit ist jeweils ein als Zylinderlinse ausgebildetes Refraktionselement 348 bzw. 352 vorgesehen, welches bevorzugt einstückig mit dem Streuelement ausgebildet ist. Die Zylinderlinsen weisen jeweils eine Eintrittsfläche 348a bzw. 352a und eine Austrittsfläche 348b bzw. 352b auf. Wie aus Figur 3 ersichtlich, bewirken die Refraktionselemente 348 und 352 eine Vergrößerung der Bandbreite der effektiven Beleuchtungswinkel, so dass auch das zu vermessende Messobjekt 372 bei einer kompakten Bauweise der Beleuchtungsvorrichtung 330 mit einer großen Bandbreite an unterschiedlichen Beleuchtungswinkeln beleuchtet wird. Auf diese Weise wird eine homogene Beleuchtung mit einer hohen Beleuchtungsintensität erzielt, wobei die Homogenität der Beleuchtung zusätzlich durch die Licht streuenden Eigenschaften des Streuelements 344 weiter verbessert wird. Auf diese Weise ist das von der Kamera 310 aufgenommene Bild des Messobjektes 372 weitgehend frei von Lichtreflexionen, welche eine nachfolgende Bildauswertung störend würden.

### Bezugszeichenliste

- 100: Bilderkennungssystem
- 110: Kamera
- 111: Gehäuse
- 112: CCD-Sensor
- 120: Tubus
- 121: Optik
- 122: Teilerwürfel
- 122a: Strahl teilende Grenzfläche
- 130: Beleuchtungsvorrichtung
- 131: Gehäuse
- 135: gemeinsame Leiterplatte
- 136: elektronische Bauelemente für Treiberschaltungen
- 140: erste Beleuchtungseinheit
- 141: innere Leuchtdioden
- 142: äußere Leuchtdioden
- 144: Streuscheibe
- 145: Öffnung
- 150: zweite Beleuchtungseinheit (Leuchtdioden)
- 151: Lichtleitelement
- 151a: Eintrittsfläche
- 151b: Austrittsfläche
- d: Abstand Austrittsfläche - Leiterplatte
- β: zweiter Beleuchtungswinkel
- 160: dritte Beleuchtungseinheit
- 161: Leuchtdiode
- 162: Leuchtdiode
- 164: Umlenkspiegel
- 170: Messfeld
- 171: Messobjekt
- 200: Bilderkennungssystem
- 210: Kamera
- 211: Gehäuse
- 212: CCD-Sensor
- 220: Tubus
- 221: Optik
- 230: Beleuchtungsvorrichtung
- 231: Gehäuse
- 235a: gemeinsame Leiterplatte
- 235b: gemeinsame Leiterplatte
- 240: erste Beleuchtungseinheit
- 241: untere Leuchtdioden
- 242: obere Leuchtdioden
- 244: Streuelement
- 246: Halterung
- 250: zweite Beleuchtungseinheit (Leuchtdiode)
- 252: Refraktionselement (Prisma)
- 252a: Eintrittsfläche
- 252b: Austrittsfläche
- β: zweiter Beleuchtungswinkel (mit Refraktionselement)
- β₀: zweiter Beleuchtungswinkel (ohne Refraktionselement)
- 270: Messfeld
- 272: Messobjekt (gewölbtes Bauelement)
- 275: Anschlussfläche
- 276: Leiterplatte
- 290: optische Achse der Beleuchtungsvorrichtung
- 300: Bilderkennungssystem
- 310: Kamera
- 311: Gehäuse
- 312: CCD-Sensor
- 320: Tubus
- 321: Optik
- 330: Beleuchtungsvorrichtung
- 335a: gemeinsame Leiterplatte
- 335b: gemeinsame Leiterplatte
- 340: erste Beleuchtungseinheit (Leuchtdioden)
- 344: Streuelement
- 348: Refraktionselement (Zylinderlinse)
- 348a: Eintrittsfläche
- 348b: Austrittsfläche
- 350: zweite Beleuchtungseinheit (Leuchtdioden)
- 352: Refraktionselement (Zylinderlinse)
- 352a: Eintrittsfläche
- 352b: Austrittsfläche
- 370: Messfeld
- 372: Messobjekt (gewölbtes Bauelement)
- 375: Anschlussfläche
- 376: Leiterplatte
- 390: optische Achse der Beleuchtungsvorrichtung

## Patentansprüche

1. Vorrichtung zum Beleuchten von Objekten, insbesondere zum Beleuchten von elektronischen Bauelementen und/oder von auf Bauelementeträgern aufgebrachten Markierungen, mit
• einer ersten Beleuchtungseinheit (140, 240, 340) zum Beleuchten eines Messfeldes (170, 270, 370) unter einem ersten Beleuchtungswinkel,
• einer zweiten Beleuchtungseinheit (150, 250, 350) zum Beleuchten des Messfeldes (170, 270, 370) unter einem zweiten Beleuchtungswinkel (β),
wobei zwischen der zweiten Beleuchtungseinheit (150, 250, 350) und dem Messfeld (170, 270, 370) ein optisches Element (151, 252, 352) angeordnet ist, welches den Strahlengang zwischen der zweiten Beleuchtungseinheit (150, 250, 350) und dem Messfeld (170, 270, 370) derart beeinflusst, dass der Strahlengang außerhalb der direkten geometrischen Verbindung zwischen der zweiten Beleuchtungseinheit (150, 250, 350) und dem Messfeld (170, 270, 370) verläuft, und
wobei die erste Beleuchtungseinheit (140, 240, 340) und die zweite Beleuchtungseinheit (150, 250, 350) an einem gemeinsamen Schaltungsträger (135, 235a/b, 335a/b) angebracht sind.

2. Vorrichtung nach Anspruch 1, zusätzlich mit einer dritten Beleuchtungseinheit (160) zum Beleuchten des Messfeldes (170) unter einem dritten Beleuchtungswinkel, wobei die dritte Beleuchtungseinheit (160) ebenfalls an dem gemeinsamen Schaltungsträger (135) angebracht ist.

3. Vorrichtung nach Anspruch 2, zusätzlich mit einem teildurchlässigen Spiegel (122a), welcher oberhalb des Messfeldes (170) angeordnet ist und eine senkrechte Beleuchtung des Messfeldes (170) durch die dritte Beleuchtungseinheit (160) ermöglicht.

4. Vorrichtung nach einem der Ansprüche 1 bis 3, bei der die Beleuchtungseinheiten (140, 160, 240) eingerichtet sind zum Emittieren von Beleuchtungslicht in unterschiedlichen Spektralbereichen.

5. Vorrichtung nach einem der Ansprüche 1 bis 4, zusätzlich mit
einer elektronischen Treiberschaltung (136) zum Ansteuern der Beleuchtungseinheiten (140, 150, 160), wobei
die Treiberschaltung (136) ebenfalls an dem gemeinsamen Schaltungsträger (135) angebracht ist.

6. Vorrichtung nach einem der Ansprüche 1 bis 5, zusätzlich mit
einem Streuelement (144, 244, 344), welches im Strahlengang des ersten Beleuchtungslichts angeordnet ist.

7. Vorrichtung nach einem der Ansprüche 1 bis 6, bei der das optische Element (151, 252, 352) direkt oder indirekt an dem gemeinsamen Schaltungsträger (135, 235) befestigt ist.

8. Vorrichtung nach einem der Ansprüche 1 bis 7, bei der das optische Element ein Lichtleitelement (151) ist, welches
• eine mit der zweiten Beleuchtungseinheit (160) optisch gekoppelte Lichteintrittsfläche (151a) und
• eine von dem gemeinsamen Schaltungsträger (135) beabstandete Lichtaustrittsfläche (151b)
aufweist.

9. Vorrichtung nach einem der Ansprüche 1 bis 7, bei der das optische Element ein Refraktionselement (252, 352) ist, welches von der zweiten Beleuchtungseinheit (250, 350) beabstandet angeordnet ist und
den Strahlengang zwischen der zweiten Beleuchtungseinheit (250, 350) und dem Messfeld (270, 370) durch Brechung an zumindest einer Grenzfläche des Refraktionselements (252, 352) beeinflusst.

10. Vorrichtung nach Anspruch 9, bei der das Refraktionselement ein optisches Prisma (252) aufweist.

11. Vorrichtung nach Anspruch 9, bei der das Refraktionselement eine Zylinderlinse (352) aufweist.

12. Vorrichtung nach einem der Ansprüche 9 bis 11, bei der das Refraktionselement (252, 352) derart ausgebildet ist, dass es zusätzlich eine Lichtstreuung bewirkt.

13. Sensorvorrichtung zur visuellen Erfassung von Objekten, insbesondere zur Erfassung von elektronischen Bauelementen und/oder von auf Bauelementeträgern aufgebrachten Markierungen, mit
• einem Lichtdetektor (112, 212, 312) und
• einer Vorrichtung (130, 230, 330) zum Beleuchten von Objekten (171, 272, 372) nach einem der Ansprüche 1 bis 11.

14. Sensorvorrichtung nach Anspruch 13, bei der der Lichtdetektor ein Zeilen- oder ein Flächensensor (112, 212, 312) ist.
